# EUROPEAN PATENT APPLICATION

(11) **EP 4 766 056 A1**
(43) Date of publication of application: **24.06.2026**
(21) Application number: 25217201.0
(22) Date of filing: 20.11.2025
(51) Int. Cl.: H05K 7/20

(54) **HEAT ABSORBING PLATE**

(30) Priority: 17.12.2024 JP 2024220921
(71) Applicant: AISIN CORPORATION, Aichi 448-8650 (JP)
(72) Inventor: NAGAI, Yuki, Aichi, 448-8650 (JP); KOASHI, Hidefumi, Aichi, 448-8650 (JP); MIZUNO, Yuya, Aichi, 448-8650 (JP); SUGIMOTO, Noriaki, Aichi, 448-8650 (JP)
(74) Representative: Kramer Barske Schmidtchen Patentanwälte PartG mbB

(57) **Abstract**

A heat absorbing plate (A) includes: a plate surface (10a) in contact with a first bottom surface (1a) of a first electronic component (1) and a second bottom surface (2a) of a second electronic component (2) that generates a relatively smaller amount of heat than the first electronic component (1); and a flow path (P) formed inside the heat absorbing plate (A) to flow therethrough a heat absorbing liquid (F) that absorbs heat generated by the first and second electronic components (1, 2), the flow path (P) including: a first flow path portion (P1); and a second flow path portion (P2) relatively smaller in a height and a cross-sectional area than the first flow path portion (P1). The heat absorbing liquid (F) exchanges heat with the first electronic component (1) in the first flow path portion (P1) and the second electronic component (2) in the second flow path portion (P2).

## Description

### TECHNICAL FIELD

The present disclosure relates to a heat absorbing plate.

### BACKGROUND DISCUSSION

Conventionally, a heat absorbing plate is known that absorbs heat generated in an electronic component and thereby suppresses a temperature rise of the electronic component. In the heat absorbing plate, an electronic component that generates heat is in contact with a surface of the heat absorbing plate so that the generated heat conducts to the heat absorbing plate, and the heat is absorbed by the heat absorbing liquid. As a technique related to such a heat absorbing plate, for example, there is a technique described in JP 2020-010469 A, the source of which is described below.

JP 2020-010469 A discloses a heat absorbing plate (a water jacket in JP 2020-010469 A) used in a power control unit mounted on a plug-in hybrid electric vehicle. In the heat absorbing plate, there is formed a flow path through which a heat absorbing liquid (cooling water in JP 2020-010469 A) flows. The power control unit includes a plug-in charger, a smoothing module, a power module, a DC-DC converter, and a bus bar module. These electronic components are disposed so as to be in contact with an isolation wall of the heat absorbing plate. Heat generated in each electronic component is conducted from the isolation wall to the heat absorbing liquid, and the heat is exchanged with the heat absorbing liquid. As a result, the heat generated in each electronic component is absorbed by the heat absorbing liquid.

In the heat absorbing plate in JP 2020-010469 A, a flow path height and a flow path cross-sectional area are constant. On the other hand, the plug-in charger, the smoothing module, the power module, the DC-DC converter, and the bus bar module generate different amounts of heat. In order to absorb heat of an electronic component that generates a relatively large amount of heat, it is preferable that a flow velocity of a heat absorbing liquid flowing through a flow path is relatively slow, and, in order to absorb heat of an electronic component that generates a relatively small amount of heat, the flow velocity of a heat absorbing liquid flowing through the flow path does not have to be made relatively slow. A flow velocity of a heat absorbing liquid flowing through a flow path is inversely proportional to a flow path cross-sectional area. In the heat absorbing plate of JP 2020-010469 A, since the flow path cross-sectional area is constant, the flow velocity of the heat absorbing liquid is constant. Therefore, it is impossible to efficiently absorb both the heat of the electronic component that generates a relatively large amount of heat and the heat of the electronic component that generates a relatively small amount of heat, and there is room for improvement.

A need thus exists for a heat absorbing plate that is capable of efficiently absorbing both heat of an electronic component that generates a relatively large amount of heat and heat of an electronic component that generates a relatively small amount of heat.

### SUMMARY

One embodiment of a heat absorbing plate according to the present disclosure is a heat absorbing plate including: a plate surface that is in contact with a first bottom surface of a first electronic component and a second bottom surface of a second electronic component that generates a relatively smaller amount of heat than the first electronic component; and a flow path that is formed inside the heat absorbing plate and through which a heat absorbing liquid that absorbs heat generated by the first electronic component and the second electronic component flows, the flow path including: a first flow path portion; and a second flow path portion that is relatively smaller in a flow path height and a flow path cross-sectional area than the first flow path portion. In addition, the heat absorbing liquid exchanges heat with the first electronic component in the first flow path portion and exchanges heat with the second electronic component in the second flow path portion.

In the heat absorbing plate according to the present embodiment, the flow path height and the flow path cross-sectional area are made relatively large in the first flow path portion in which the heat of the first electronic component is absorbed by the heat absorbing liquid, so that the flow velocity of the heat absorbing liquid is slow, and the flow path height and the flow path cross-sectional area are made relatively small in the second flow path portion in which the heat of the second electronic component that generates a relatively smaller amount of heat than the first electronic component is absorbed by the heat absorbing liquid, so that the flow velocity of the heat absorbing liquid is fast. When the same amount of heat is conducted, the amount of heat absorbed per unit volume of the heat absorbing liquid is larger when the flow velocity is slower because the amount of heat conducted to the heat absorbing liquid per unit time is accordingly larger. As a result, the heat absorbing plate has been obtained that can efficiently absorb both heat of the first electronic component and heat of the second electronic component that generates a relatively smaller amount of heat than the first electronic component by the heat absorbing liquid.

### BRIEF DESCRIPTION OF THE DRAWINGS

The foregoing and additional features and characteristics of this disclosure will become more apparent from the following detailed description considered with the reference to the accompanying drawings, wherein:
Fig. 1 is a perspective view illustrating a schematic configuration of a power control unit including a heat absorbing plate according to the present embodiment; and
Fig. 2 is a cross-sectional view taken along line II-II in Fig. 1.

### DETAILED DESCRIPTION

Hereinafter, an embodiment of a heat absorbing plate according to the present disclosure will be described in detail with reference to the drawings. Note that the embodiments described below are examples for describing the heat absorbing plate according to the present disclosure, and the heat absorbing plate is not limited only to these embodiments. Therefore, the heat absorbing plate according to the present disclosure can be implemented in various forms without departing from the gist of the disclosure.

### [Configuration of heat absorbing plate]

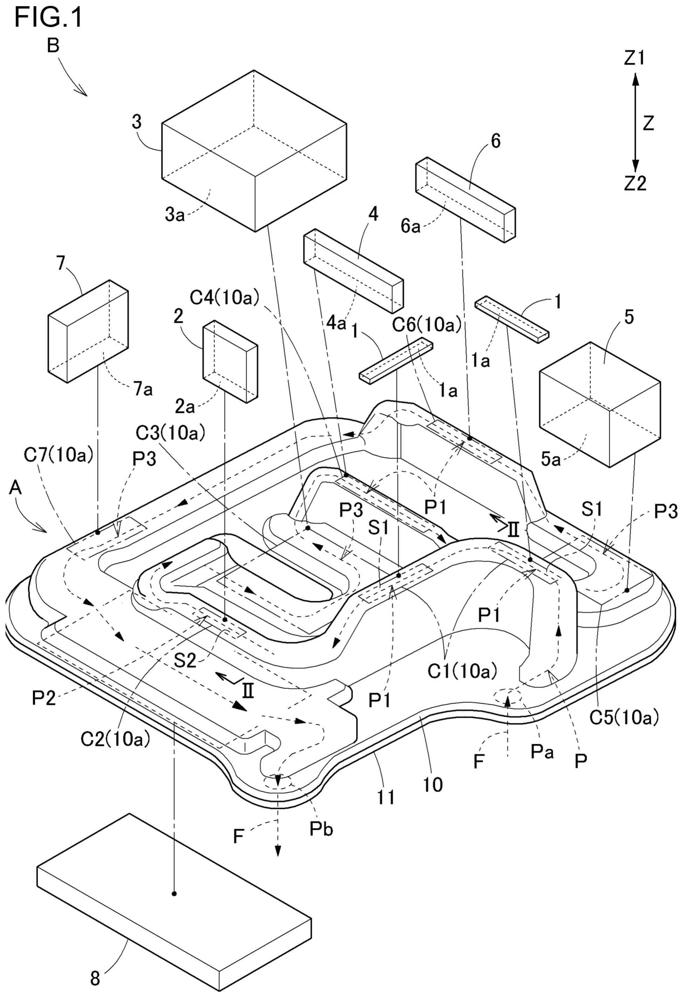

Fig. 1 illustrates a power control unit B including a heat absorbing plate A provided in a vehicle (not illustrated) such as a hybrid electric vehicle (HEV), a plug-in hybrid electric vehicle (PHEV), a battery electric vehicle (BEV), and a fuel cell electric vehicle (FCEV) that can travel by electric power.

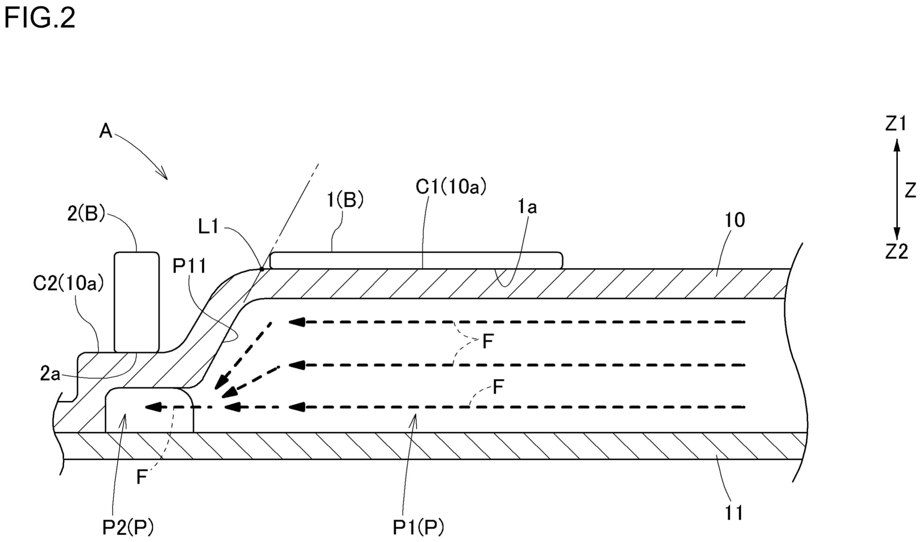

The power control unit B according to the present embodiment includes the heat absorbing plate A and a plurality of electronic components from which heat is to be absorbed by the heat absorbing plate A. The heat absorbing plate A is formed by joining, by welding or the like, a pair of an upper plate member 10 and a lower plate member 11 that are made of metal such as aluminum having high thermal conductivity (see Figs. 1 and 2). Specifically, the plurality of electronic components include a pair of primary power modules 1 (an example of a first electronic component), a secondary power module 2 (an example of a second electronic component), a transformer coil 3, a first FET 4, a PFC coil 5, a second FET 6, a secondary coil 7, and an inverter 8. Note that the heat absorbing plate A is not necessarily configured with the upper plate member 10 and the lower plate member 11. The heat absorbing plate A may be configured with one component or three or more components.

Since the heat absorbing plate A is provided in a vehicle in the posture illustrated in Fig. 1, a vertical relationship of each part of the heat absorbing plate A will be described in accordance with this posture. Hereinafter, the vertical direction is referred to as a Z direction, the side and the direction where the upper plate member 10 is disposed with respect to the lower plate member 11 are referred to as a Z1 side and a Z1 direction, and the side and the direction where the lower plate member 11 is disposed with respect to the upper plate member 10 are referred to as a Z2 side and a Z2 direction. In this situation, the Z2 direction is a gravity direction, and the Z1 direction is a direction opposite to the gravity direction (hereinafter, also referred to as "anti-gravity direction").

Among the plurality of electronic components, the pair of primary power modules 1, the secondary power module 2, the transformer coil 3, the first FET 4, the PFC coil 5, the second FET 6, and the secondary coil 7 are disposed on the Z1 side, which is the upper plate member 10 side, of the heat absorbing plate A, and inverter 8 is disposed on the Z2 side, which is the lower plate member 11 side.

Inside the heat absorbing plate A, a flow path P is formed of a groove formed in at least one of the pair of upper plate member 10 and lower plate member 11. A heat absorbing liquid F flows through the flow path P. The heat absorbing liquid F absorbs heat generated by the plurality of electronic components included in the power control unit B, and suppresses a temperature rise of the plurality of electronic components. Hereinafter, an action and effect of such a heat absorbing liquid F is also simply described as "the heat absorbing liquid F absorbs the heat of the electronic components". The lower plate member 11 has a supply port Pa at one end of the flow path P and a discharge port Pb at the other end of the flow path P. The heat absorbing liquid F flowing through the outside of the heat absorbing plate A flows into the heat absorbing plate A through the supply port Pa, flows through the flow path P, and is discharged to the outside through the discharge port Pb. The heat absorbing liquid F includes an antifreeze liquid containing ethylene glycol or the like as a main component, an aqueous liquid such as a long life coolant, or an oil-based liquid including an insulating oil such as paraffinic oil. The heat absorbing liquid F is a generic term for those liquids.

As illustrated in Fig. 1, the upper plate member 10 has a plate surface 10a with which each of the pair of primary power modules 1, the secondary power module 2, the transformer coil 3, the first FET 4, the PFC coil 5, the second FET 6, and the secondary coil 7 is in contact. Specifically, the plate surface 10a is a part of: first heat absorption parts C1 that absorb heat of the pair of primary power modules 1; a second heat absorption part C2 that absorbs heat of the secondary power module 2; a third heat absorption part C3 that absorbs heat of the transformer coil 3, a fourth heat absorption part C4 that absorbs heat of the first FET 4, a fifth heat absorption part C5 that absorbs heat of the PFC coil 5, a sixth heat absorption part C6 that absorbs heat of the second FET 6, and a seventh heat absorption part C7 that absorbs heat of the secondary coil 7.

In the present embodiment, first bottom surfaces 1a of the pair of primary power modules 1 are in contact with the plate surface 10a of the first heat absorption parts C1. A second bottom surface 2a of the secondary power module 2 is in contact with the plate surface 10a of the second heat absorption part C2. A third bottom surface 3a of the transformer coil 3 is in contact with the plate surface 10a of the third heat absorption part C3. A fourth bottom surface 4a of the first FET 4 is in contact with the plate surface 10a of the fourth heat absorption part C4. A fifth bottom surface 5a of the PFC coil 5 is in contact with the plate surface 10a of the fifth heat absorption part C5. A sixth bottom surface 6a of the second FET 6 is in contact with the plate surface 10a of the sixth heat absorption part C6. A seventh bottom surface 7a of the secondary coil 7 is in contact with the plate surface 10a of the seventh heat absorption part C7. Note that the term "in contact" includes not only an aspect in which the electronic components are in direct contact with the plate surface 10a but also an aspect in which the plate surface 10a and the electronic components are in contact with each other via thermal conductive sheets or gap fillers, an aspect in which the plate surface 10a is close to the electronic components to such an extent that thermal conduction is not significantly hindered, and other aspects.

The flow path P is formed so as to pass through at least immediately below (Z2 side) the plate surface 10a of each of the first heat absorption parts C1 to the seventh heat absorption part C7. A thickness of a wall between the plate surface 10a and the flow path P in the upper plate member 10 (a distance between the plate surface 10a and the flow path P) is preferably as thin as possible within a range in which strength required for the upper plate member 10 can be secured. As a result, the heat absorbing liquid F flowing through the flow path P can efficiently absorb the heat of the electronic components.

With such a configuration, for example, the heat of the pair of primary power modules 1 is conducted from the first bottom surface 1a to the inside of the upper plate member 10 through the plate surface 10a, and is absorbed by the heat absorbing liquid F flowing through the flow path P. As a result, the temperature rise of the pair of primary power modules 1 that have released heat is suppressed, and the temperature of the heat absorbing liquid F that has absorbed the heat rises. Similarly, the heat of each of the secondary power module 2 to the secondary coil 7 is conducted from the second bottom surface 2a to the seventh bottom surface 7a to the inside of the upper plate member 10 through the plate surface 10a, and is absorbed by the heat absorbing liquid F flowing through the flow path P. This suppresses the temperature rise of each of the secondary power module 2 to the secondary coil 7 that have released heat, and the temperature of the heat absorbing liquid F that has absorbed heat at the location of each of the secondary power module 2 to the secondary coil 7 rises.

As illustrated in Fig. 1, the pair of primary power modules 1, the secondary power module 2, the transformer coil 3, the first FET 4, the PFC coil 5, the second FET 6, and the secondary coil 7 have different heights (lengths along the Z direction), and generate different amounts of heat. Specifically, in each of the pair of primary power modules 1, the first FET 4, and the second FET 6 generate a relatively large amount of heat, and the transformer coil 3, the PFC coil 5, and the secondary coil 7 generate a relatively small amount of heat. The secondary power module 2 generates a relatively intermediate amount of heat.

In order to efficiently absorb, by the heat absorbing liquid F, the heat of these electronic components that generate different amount of heat, the flow path height (the length along the Z direction) and the flow path cross-sectional area of the flow path P differ depending on the amounts of heat generated by the opposing electronic components. That is, in the first heat absorption parts C1, the fourth heat absorption part C4, and the sixth heat absorption part C6 that respectively face the pair of primary power modules 1, the first FET 4, and the second FET 6 that generate a relatively large amount of heat, the flow path height of the flow path P is enlarged to be relatively high in the Z1 direction (anti-gravity direction) approaching the electronic component, and the flow path cross-sectional area is made relatively large. Hereinafter, in the flow path P, portions constituting the first heat absorption parts C1, the fourth heat absorption part C4, and the sixth heat absorption part C6 are referred to as a first flow path portion P1.

On the other hand, in the third heat absorption part C3, the fifth heat absorption part C5, and the seventh heat absorption part C7 that respectively face the transformer coil 3, the PFC coil 5, and the secondary coil 7 that generate a relatively small amount of heat, the flow path height and the flow path cross-sectional area of the flow path P are made relatively smaller than those of the first flow path portion P1. Hereinafter, in the flow path P, portions constituting the third heat absorption part C3, the fifth heat absorption part C5, and the seventh heat absorption part C7 are referred to as a third flow path portion P3. Furthermore, in the second heat absorption part C2 facing the secondary power module 2 that generates a relatively intermediate amount of heat, both the flow path height and the flow path cross-sectional area of the flow path P are set to intermediate sizes between those of the first flow path portion P1 and the third flow path portion P3. Hereinafter, a portion constituting the second heat absorption part C2 in the flow path P is referred to as a second flow path portion P2.

In the flow path P of the present embodiment, as shown in Fig. 1, the second flow path portion P2 constituting the second heat absorption part C2 is disposed on the downstream side from the first flow path portion P1 constituting the first heat absorption parts C1, and the third flow path portion P3 constituting the third heat absorption part C3 is disposed on the downstream side from the second flow path portion P2. As described above, the flow path height and the flow path cross-sectional area of the flow path P decrease in the order of the first flow path portion P1, the second flow path portion P2, and the third flow path portion P3.

In the first flow path portion P1 constituting the first heat absorption parts C1, the heat generated in the pair of primary power modules 1 is exchanged with the heat absorbing liquid F. In the second flow path portion P2 constituting the second heat absorption part C2, the heat generated in the secondary power module 2 is exchanged with the heat absorbing liquid F. In the third flow path portion P3 constituting the third heat absorption part C3, the heat generated in the transformer coil 3 is exchanged with the heat absorbing liquid F.

The heat absorbing liquid F having flown in from the supply port Pa flows through the first flow path portion P1 constituting the first heat absorption parts C1. As illustrated in Fig. 2, an inner wall surface of the first flow path portion P1 extends close to and parallel to the plate surface 10a. On the downstream side of the inner wall surface, the inner wall surface extends from an end of the parallelly extending inner surface, in the Z2 direction away from the primary power module 1 and in the direction inclined with respect to the downstream direction. Hereinafter, of the inner wall surface constituting the first flow path portion P1, the wall surface of the downstream end of the inner wall surface extending in a direction inclined with respect to the Z direction is referred to as an inclined surface P11. Regarding the inclined surface P11, the flow path height and the flow path cross-sectional area at a position of the first flow path portion P1 where the first flow path portion P1 extends close to and parallel to the plate surface 10a gradually decrease and are connected to the second flow path portion P2 on the downstream side. This configuration makes it possible to cause the heat absorbing liquid F to flow through the second flow path portion P2 while gradually increasing the flow velocity of the heat absorbing liquid F.

In the present embodiment, in plan view along the direction (Z direction) perpendicular to the plate surface 10a, a first area S1 (see Fig. 1) on which (i) a portion of the first flow path portion P1 closest to the first bottom surface 1a of each of the pair of primary power modules 1 (a part of the inner wall surface of the first flow path portion P1 extending close to and parallel to the plate surface 10a) and (ii) the first bottom surface 1a overlap with each other is configured to be larger than a second area S2 (see Fig. 1) on which (i) a portion of the second flow path portion P2 closest to the second bottom surface 2a of the secondary power module 2 and (ii) the second bottom surface 2a overlap with each other. However, for example, in a case where the primary power module 1 is disposed such that a part of the first bottom surface 1a overlaps the inclined surface P11 in plan view, the portion of the first bottom surface 1a overlapping the inclined surface P11 is excluded. This is because heat is not exchanged with the heat absorbing liquid F in the portion overlapping the inclined surface P11 in plan view. In the present embodiment, since the entire surfaces of both the first bottom surfaces 1a and the second bottom surface 2a are in contact with the plate surface 10a, the area of each first bottom surface 1a is the first area S1, and the area of the second bottom surface 2a is the second area S2 (see Fig. 1).

The state where the entire surfaces of the first bottom surface 1a and the second bottom surface 2a are in contact with the plate surface 10a means the following state. Hereinafter, as an example, a case will be described in which the entire surface of the first bottom surface 1a is in contact with the plate surface 10a. As illustrated in Fig. 2, the primary power module 1 is disposed such that, when an imaginary extension surface (indicated by a one-dot chain line) extending in the direction toward the plate surface 10a along the inclined surface P11 in the first flow path portion P1 is assumed, a contact surface of the primary power module 1 in contact with the plate surface 10a is located inside an imaginary intersection line L1 on which the imaginary extension surface and the plate surface 10a intersect with each other. That is, the contact surface in contact with the plate surface 10a of the primary power module 1 is located on the upstream side in the flowing direction of the heat absorbing liquid F, with respect to the imaginary intersection line L1 in the flowing direction of the heat absorbing liquid. Since the primary power module 1 is disposed at such a position, the entire first bottom surface 1a of the primary power module 1 faces the heat absorbing liquid F in the state of being closest to the heat absorbing liquid F, so that the heat of the primary power module 1 is efficiently absorbed by the heat absorbing liquid F. Note that, similarly to the primary power module 1, the second bottom surface 2a of the secondary power module 2 is disposed such that the entire second bottom surface 2a is in contact with the plate surface 10a. Similarly, the fourth bottom surface 4a of the first FET 4, the sixth bottom surface 6a of the second FET 6, and the seventh bottom surface 7a of the secondary coil 7 are disposed such that the entire surfaces thereof are in contact with the plate surface 10a.

The flow velocity of the heat absorbing liquid F flowing through the flow path P is inversely proportional to the flow path cross-sectional area. That is, the flow velocity of the heat absorbing liquid F is the slowest when the heat absorbing liquid F flows through the first flow path portion P1 among the first flow path portion P1 to the third flow path portion P3. When the same amount of heat is conducted, the amount of heat absorbed per unit volume of the heat absorbing liquid F is larger when the flow velocity is slower, because the amount of heat conducted to the heat absorbing liquid F per unit time is larger when the flow velocity is slower. Furthermore, the first flow path portion P1 corresponding to the first heat absorption parts C1 is disposed on the most upstream side of the flow path P formed in the heat absorbing plate A, and the temperature of the heat absorbing liquid F flowing through the first flow path portion P1 is relatively low. In the present embodiment, the pair of primary power modules 1 from which heat is absorbed by the heat absorbing liquid F flowing through the first flow path portion P1 corresponding to the first heat absorption parts C1 generate a relatively large amount of heat. As described above, the heat absorbing liquid F flowing through the first flow path portion P1 corresponding to the first heat absorption parts C1 can absorb the largest amount of heat on the basis of conditions such as the flow velocity and temperature of the heat absorbing liquid F and the relatively large amount of heat generated by the primary power modules 1.

Then, the heat absorbing liquid F having absorbed the heat of the primary power modules 1 in the first flow path portion P1 gradually increases in flow velocity and flows into the second flow path portion P2. Since the second flow path portion P2 has a flow path height and a flow path cross-sectional area smaller than those of the first flow path portion P1, the flow velocity of the heat absorbing liquid F is faster than that of the first flow path portion P1. However, the secondary power module 2 generates a relatively smaller amount of heat than the primary power modules 1; therefore, even when the flow velocity of the heat absorbing liquid F is relatively fast, the heat generated in the secondary power module 2 can be sufficiently absorbed by the heat absorbing liquid F.

The heat absorbing liquid F having absorbed the heat of the secondary power module 2 in the second flow path portion P2 further increases the flow velocity and flows into the third flow path portion P3. Since the third flow path portion P3 has a flow path height and a flow path cross-sectional area smaller than those of the second flow path portion P2, the flow velocity of the heat absorbing liquid F is faster than that of the second flow path portion P2. However, the transformer coil 3 generates a relatively smaller amount of heat than the secondary power module 2; therefore, even when the flow velocity of the heat absorbing liquid F is relatively fast, the heat generated in the transformer coil 3 can be sufficiently absorbed by the heat absorbing liquid F.

As described above, the heat absorbing plate A according to the present embodiment is configured as follows. In the first flow path portion P1 in which the heat of the primary power modules 1, which generate a relatively large amount of heat, is absorbed by the heat absorbing liquid F, the flow path height and the flow path cross-sectional area are made relatively large, so that the flow velocity of the heat absorbing liquid F is made slow, and in the second flow path portion P2 in which the heat of the secondary power module 2, which generates a relatively small amount of heat, is absorbed by the heat absorbing liquid F, the flow path height and the flow path cross-sectional area are made relatively small, so that the flow velocity of the heat absorbing liquid F is made fast. When the same amount of heat is conducted, the amount of heat absorbed per unit volume of the heat absorbing liquid F is larger when the flow velocity is slower, because the amount of heat conducted to the heat absorbing liquid F per unit time is larger when the flow velocity is slower. As a result, it is possible to cause the heat absorbing liquid F to efficiently absorb both the heat of the primary power modules 1 that generate a relatively large amount of heat and the heat of the secondary power module 2 that generates a relatively small amount of heat. A similar relationship holds between the flow path P corresponding to the fourth heat absorption part C4 and the flow path P corresponding to the fifth heat absorption part C5, and between the flow path P corresponding to the sixth heat absorption part C6 and the flow path P corresponding to the seventh heat absorption part C7. That is, whether the relative amount of heat generation is large or small, the heat generated by all the electronic components in contact with the heat absorbing plate A can be efficiently absorbed by the heat absorbing liquid F.

In the heat absorbing plate A, the electronic components are disposed as follows. The primary power modules 1 that generate a relatively large amount of heat are disposed on the first flow path portion P1 corresponding to the first heat absorption parts C1 on the upstream side of the flow path P, and then the secondary power module 2 and the transformer coil 3 are disposed in the order of the second heat absorption part C2 and the third heat absorption part C3 such that the relative amount of heat generation becomes smaller toward the downstream. As a result, the heat of the primary power modules 1 that generate a relatively large amount of heat can be absorbed by the heat absorbing liquid F before the heat of the secondary power module 2 and the transformer coil 3 that generate a relatively small amount of heat is absorbed, so that the heat can be more efficiently absorbed by the heat absorbing liquid F.

Furthermore, the heat absorbing plate A is configured as follows. In plan view, the first area S1 on which (i) a portion of the first flow path portion P1 closest to the first bottom surface 1a of each of the pair of primary power modules 1, which generate a relatively large amount of heat, and (ii) the first bottom surface 1a overlap with each other is larger than the second area S2 on which (i) a portion of the second flow path portion P2 closest to the second bottom surface 2a of the secondary power module 2, which generates a relatively small amount of heat, and (ii) the second bottom surface 2a overlap with each other. As described above, since each electronic component is located close to the flow path P while having the bottom area corresponding to the relative amount of heat generation, the heat can be more efficiently absorbed by the heat absorbing liquid F.

### [Other embodiments]

(1) In the above embodiment, the entire first bottom surfaces 1a of the primary power modules 1 and the entire second bottom surface 2a of the secondary power module 2 are in contact with the plate surface 10a. However, the entire first bottom surfaces 1a may not be in contact with the plate surface 10a by, for example, disposing parts of the first bottom surfaces 1a so as to overlap the inclined surfaces P11. However, even in this case, in plan view, the first area S1 (see Fig. 1) on which (i) a portion of the first flow path portion P1 closest to the first bottom surface 1a of the first electronic component and (ii) the first bottom surface 1a overlaps with each other is larger than the second area S2 (see Fig. 1) on which (i) a portion of the second flow path portion P2 closest to the second bottom surface 2a of the second electronic component and (ii) the second bottom surface 2a overlap with each other. That is, a portion of the first bottom surface 1a overlapping the inclined surface P11 in plan view is excluded from the first area S1. This is because heat is not exchanged with the heat absorbing liquid F in the portion overlapping the inclined surface P11 in plan view.
(2) In the above embodiment, although a downstream end of the second flow path portion P2 connected to the third flow path portion P3 does not have such an inclined surface as the inclined surface P11 of the first flow path portion P1, this configuration is not limitative. An inclined surface similar to the inclined surface P11 of the first flow path portion P1 may be formed at the downstream end of the second flow path portion P2.
(3) Although not mentioned in the above embodiment, as long as the flow path height and the flow path cross-sectional area of the flow path P capable of efficiently absorbing the heat of all the electronic components are secured, the pair of primary power modules 1, the secondary power module 2, the transformer coil 3, the first FET 4, the PFC coil 5, the second FET 6, and the secondary coil 7 disposed on the Z1 side may be mounted on one substrate (not illustrated) or a plurality of substrates (not illustrated) disposed at the same height. That is, the heights of the first heat absorption parts C1 to the seventh heat absorption part C7 may be set such that the first bottom surfaces 1a to the seventh bottom surface 7a are in contact with the plate surface 10a of the upper plate member 10 in a state where the mounting surfaces of these electronic components are at the same height. With such a configuration, a mounting density of the substrate can be increased and routing of wiring can be simplified, so that the power control unit B can be manufactured at low cost.

Hereinafter, in the heat absorbing plate A described in the above embodiment, the following configurations are conceived.

<1> One aspect of a heat absorbing plate (A) is a heat absorbing plate (A) including: a plate surface (10a) that is in contact with a first bottom surface (1a) of a first electronic component (1) that generates a relatively large amount of heat and a second bottom surface (2a) of a second electronic component (2) that generates a relatively smaller amount of heat than the first electronic component (1); and a flow path (P) that is formed inside the heat absorbing plate (A) and through which a heat absorbing liquid (F) that absorbs heat generated by the first electronic component (1) and the second electronic component (2) flows, the flow path (P) including: a first flow path portion (P1) that is relatively larger in a flow path height and a flow path cross-sectional area; and a second flow path portion (P2) that is relatively smaller in a flow path height and a flow path cross-sectional area than the first flow path portion (P1). In addition, the heat absorbing liquid (F) exchanges heat with the first electronic component (1) in the first flow path portion (P1) and exchanges heat with the second electronic component (2) in the second flow path portion (P2).

In the heat absorbing plate (A) according to the present aspect, the flow path height and the flow path cross-sectional area are made relatively large in the first flow path portion (P1) in which the heat of the first electronic component (1), which generates a relatively large amount of heat, is absorbed by the heat absorbing liquid (F), so that the flow velocity of the heat absorbing liquid (F) is slow, and the flow path height and the flow path cross-sectional area are made relatively small in the second flow path portion (P2) in which the heat of the second electronic component (2), which generates a relatively small amount of heat, is absorbed by the heat absorbing liquid (F), so that the flow velocity of the heat absorbing liquid (F) is fast. When the same amount of heat is conducted, the amount of heat absorbed per unit volume of the heat absorbing liquid (F) is larger when the flow velocity is slower, because the amount of heat conducted to the heat absorbing liquid (F) per unit time is larger when the flow velocity is slower. As a result, the heat absorbing plate (A) has been obtained that can efficiently absorb both heat of the first electronic component (1), which generates a relatively large amount of heat, and heat of the second electronic component (2) that generates a relatively small amount of heat by the heat absorbing liquid (F).

<2> In the heat absorbing plate (A) according to the above <1>, as viewed in a direction perpendicular to the plate surface (10a), a first area (S1) on which a portion of the first flow path portion (P1) closest to the first bottom surface (1a) of the first electronic component (1) overlaps the first bottom surface (1a) is preferably larger than a second area (S2) on which a portion of the second flow path portion (P2) closest to the second bottom surface (2a) of the second electronic component (2) overlaps the second bottom surface (2a).

According to the present aspect, as viewed in a direction perpendicular to the plate surface (10a), the first area (S1) on which the portion of the first flow path portion (P1) closest to the first bottom surface (1a) of the first electronic component (1), which generates a relatively large amount of heat, overlaps with the first bottom surface (1a) is configured to be larger than the second area (S2) on which the portion of the second flow path portion (P2) closest to the second bottom surface (2a) of the second electronic component (2), which generates a relatively small amount of heat, overlaps with the second bottom surface (2a). As described above, since the first electronic component (1) and the second electronic component (2) are located close to the flow path (P) while having the bottom area corresponding to the relative amount of heat generation, the heat can be more efficiently absorbed by the heat absorbing liquid (F).

<3> In the heat absorbing plate (A) according to the above <1> or <2>, in the flow path (P), the second flow path portion (P2) is preferably disposed on a downstream side from the first flow path portion (P1).

According to the present aspect, the first electronic component (1) that generates a relatively large amount of heat is disposed in the first flow path portion (P1) on the upstream side of the flow path (P), and the second electronic component (2) having a relatively small heat generation amount is disposed in the second flow path portion (P2) that is located on the downstream side. As a result, the heat of the first electronic component (1) that generates a relatively large amount of heat can be absorbed by the heat absorbing liquid (F) before the heat of the second electronic component (2) that generates a relatively small amount of heat is absorbed, so that the heat can be more efficiently absorbed by the heat absorbing liquid (F).

<4> In the heat absorbing plate (A) according to any one of the above <1> to <3>, the flow path (P) preferably includes a third flow path portion (P3) having the flow path height and the flow path cross-sectional area that are relatively smaller than the flow path height and the flow path cross-sectional area of the second flow path portion (P2), and, in the flow path (P), the third flow path portion (P3) is preferably disposed on a downstream side from the second flow path portion (P2).

According to the present aspect, the second flow path portion (P2) is disposed on the relatively upstream side on the flow path (P), and the third flow path portion (P3) having a flow path height and a flow path cross-sectional area relatively smaller than those of the second flow path portion (P2) is disposed on the relatively downstream side. As a result, by disposing the second electronic component (2) that generates a relatively large amount of heat in the second flow path portion (P2) and by disposing an electronic component that generates a relatively smaller amount of heat than the second electronic component (2) in the third flow path portion (P3), the heat of the second electronic component (2) that generates a relatively large amount of heat can be absorbed by the heat absorbing liquid (F) before the heat of the electronic component that generates a relatively small amount of heat is absorbed, so that the heat can be more efficiently absorbed by the heat absorbing liquid (F).

<5> In the heat absorbing plate (A) according to the above <4>, it is preferable that a downstream end of at least one of the first flow path portion (P1) and the second flow path portion (P2) gradually decrease in the flow path height and the flow path cross-sectional area and be connected to the second flow path portion (P2) and the third flow path portion (P3).

According to the present aspect, since the flow velocity of the heat absorbing liquid (F) can be gradually increased, the heat absorbing liquid (F) can be smoothly circulated through the second flow path portion (P2).

The present disclosure is applicable to a heat absorbing plate.

It is explicitly stated that all features disclosed in the description and/or the claims are intended to be disclosed separately and independently from each other for the purpose of original disclosure as well as for the purpose of restricting the claimed invention independent of the composition of the features in the embodiments and/or the claims. It is explicitly stated that all value ranges or indications of groups of entities disclose every possible intermediate value or intermediate entity for the purpose of original disclosure as well as for the purpose of restricting the claimed invention, in particular as limits of value ranges.

## Claims

1. A heat absorbing plate (A) comprising:
a plate surface (10a) that is in contact with a first bottom surface (1a) of a first electronic component (1) and a second bottom surface (2a) of a second electronic component (2) that generates a relatively smaller amount of heat than the first electronic component (1); and
a flow path (P) that is formed inside the heat absorbing plate (A) and through which a heat absorbing liquid (F) that absorbs heat generated by the first electronic component (1) and the second electronic component (2) flows, the flow path (P) including:
a first flow path portion (P1); and
a second flow path portion (P2) that is relatively smaller in a flow path height and a flow path cross-sectional area than the first flow path portion (P1),
wherein the heat absorbing liquid (F) exchanges heat with the first electronic component (1) in the first flow path portion (P1) and exchanges heat with the second electronic component (2) in the second flow path portion (P2).

2. The heat absorbing plate (A) according to Claim 1, wherein, as viewed in a direction perpendicular to the plate surface (10a), a first area (S1) on which a portion of the first flow path portion (P1) closest to the first bottom surface (1a) of the first electronic component (1) overlaps the first bottom surface is larger than a second area (S2) on which a portion of the second flow path portion (P2) closest to the second bottom surface (2a) of the second electronic component (2) overlaps the second bottom surface (2a).

3. The heat absorbing plate (A) according to Claim 1 or 2, wherein the flow path (P) includes a third flow path portion (P3) having the flow path height and the flow path cross-sectional area that are relatively smaller than the flow path height and the flow path cross-sectional area of the second flow path portion (P2), and
in the flow path (P), the third flow path portion (P3) is disposed on a downstream side from the second flow path portion (P2) in a flowing direction.

4. The heat absorbing plate (A) according to Claim 3, wherein a downstream end of at least one of the first flow path portion (P1) and the second flow path portion (P2) gradually decreases in the flow path height and the flow path cross-sectional area and is connected to the second flow path portion (P2) or the third flow path portion (P3).

5. The heat absorbing plate (A) according to Claim 4, wherein an inclined surface inclined downward from upper in a gravity direction is formed at the downstream end along the downstream direction.
